# EUROPEAN PATENT APPLICATION

(11) **EP 1 727 195 A2**
(43) Date of publication of application: **29.11.2006**
(21) Application number: 06114371.5
(22) Date of filing: 23.05.2006
(51) Int. Cl.: H01L 21/762

(54) **Method for high topography patterning**

(30) Priority: 27.05.2005 EP 05447123
(71) Applicant: INTERUNIVERSITAIR MICROELEKTRONICA CENTRUM ( IMEC), 3001 Leuven (BE)
(72) Inventor: Verhaegen, Gustaaf, 2580, Putte (BE); Nackaerts, Axel, 3053, Haasrode (BE)
(74) Representative: Van Malderen, Joëlle

(57) **Abstract**

The present invention is related to a method for isolating structures of a semiconductor material, comprising the steps of :
- providing a pattern of the semiconductor material comprising at least one elevated line,
- defining device regions in said pattern, said device regions each comprising at least said at least one elevated line, and
- modifying the conductive properties of said semiconductor material outside said device regions, such that the device regions are electrically isolated.

## Description

### Field of the invention

The present invention relates to a method for isolating structures within a semiconductor device with high topography. It also relates to a multi-gate device obtained via application of the method of the invention.

### State of the art

Topography is a crucial part of device processing. This holds even more for Multi-Gate devices, which are regarded as possible alternatives for classical CMOS devices in sub-45nm technologies. The term 'Multi-Gate device' or `MuGFET' refers to a family of devices known in literature as FinFETs, Tri-gate, Omega-gate, Pi-gate, etc. Multi-gate FETs have been proposed as an option for the extremely short FET as due to the gate geometry they have superior short-channel effect immunity and control over bulk devices in the sub-30nm physical gate length regime.

In a FinFET the gate at least partially envelops the channel region, as opposed to the classic planar device where the gate electrode is formed in one plane on top of the channel region, which is part of the substrate. The FinFET further comprises the source and drain regions adjacent to the channel region.

Important issues in the fabrication of these devices are e.g. the patterning of 25 nm gates over high topography due to the fins. In MUGFETs the active area is patterned from a semiconductor layer as e.g. SOI (Silicon On Insulator) layer of the order of tens of nm thick or a GOI (Germanium On Insulator) layer or SiGe layer, and consists of source and drain connected by fins. Narrow fins are required to have a better short channel effect control: typically the physical width of the fin should be about half of the gate length. The channel width on the other hand is determined by the height of the fin: the higher the fin, the more current can flow from source to drain. Therefore the gate stack is deposited on a surface with an intrinsically high topography.

In order to achieve small active areas, an important issue is how to maintain proper control when the lines patterned on semiconductor material are etched to separate the various FinFETs on the wafer. For controlling the critical dimension it is best to use dense long lines. With critical dimension (CD) is meant the dimension of the smallest geometrical feature (width of interconnect line, contacts, trenches, etc.) which can be formed during semiconductor device manufacturing using a given technology.

However, a problem with said dense long lines patterned on semiconductor material is that their width is locally difficult to control where an open area in the line is to be provided. Various solutions to the problem have been proposed, like e.g. performing a double patterning in the resist (fin layer). This allows good control of critical dimension as well as an easier gap control. However, it creates regions with high and low topography. Alternatively, a double patterning in a hard mask or a double patterning with a second etch can be envisaged.

Another difficulty is that the density of the high topography pattern influences the processing of the layers on top of the high topography layer. This renders the CD control on said next layers more difficult, because a CD difference can be seen above regions with different density. A solution used nowadays is that extra dummy features are placed in the high topography layer in regions where there weren't any present. This solution is limited because these dummy features have to be placed at a big enough distance away from the active devices as not to influence their electrical behaviour. Another solution to mitigate the above-mentioned drawback, that can be used in addition to said dummy features, consists in applying a poly etch-back step (gate layer). This is performed on top of the fins. This solution however is limited in the planarisation capability and still differences may be present in regions with substantial pattern density difference.

As already mentioned one prefers to have narrow fins in order to better control the short channel effect. Moreover they are advantageous in terms of space. An interesting way to achieve these goals is by applying spacer defined fins. Typically spacer defined fins are obtained by using a sacrificial layer. When this sacrificial layer is etched, two narrow spacers remain. The spacer defined fins are described in detail e.g. in (EP 1383166, US-6706571-B).

### Aims of the invention

The present invention aims to provide a method for high topography patterning that results in a uniform pattern density which eases the next processing steps and results in relaxed requirements for the active patterning lithography. The invention also aims to provide a multi-gate device resulting from the application of said method.

### Summary of the invention

The present invention relates to a method for isolating structures of a semiconductor material, comprising the steps of:
- providing a pattern of the semiconductor material comprising at least one elevated line,
- defining device regions in said pattern, said device regions each comprising at least said at least one elevated line, and
- modifying the conductive properties of the semiconductor material outside said device regions, such that the device regions are isolated.

In a preferred embodiment the method step of defining device regions is performed by covering the device regions with a hard mask. The hard mask preferably is a non-oxidising material. Advantageously the hard mask is formed of nitride.

In a preferred embodiment the step of modifying the conductive properties is performed by turning the semiconductor material outside the device regions into dielectric material.

In case the hard mask is a non-oxidising material, the modifying step comprises a selective oxidation step.

Alternatively said modifying step comprises forming a PN junction between the device regions and the semiconductor material outside the device regions.

In a specific embodiment the dense high topography pattern is obtained by a lithographic patterning step comprising interferometry.

In another preferred embodiment the dense high topography pattern comprises a plurality of parallel lines. In an advantageous embodiment the plurality of parallel lines is obtained by patterning a dedicated layer for creating spacer defined fins by etching.

Preferably the semiconductor material is a Sol, a GoI or a SiGe layer. The at least one elevated line can also be a semiconductor nanocarbon tube or a nanowire.

In another aspect the invention relates to a multi-gate device comprising a pattern comprising at least one elevated line of a semiconductor material and device regions defined in said pattern. The device regions each comprise at least said at least one elevated line, whereby the device regions are electrically isolated by isolation regions defined in the semiconductor material of the at least one elevated line.

In a further aspect the invention relates to a multi-gate device obtained by performing the steps of the method as previously described, wherein the pattern of semiconductor material comprises a plurality of elevated lines and whereby a device region for the multi-gate device is defined. The plurality of elevated lines defines a pattern of fins wherein the device region for the multi-gate device is provided.

### Short description of the drawings

Fig. 1 represents the steps of the method of the invention. In Fig.1A the step of providing a dense high topography pattern (either by conventional lithography, interferometry or spacer defined fin) is shown. In Fig. 1B device regions are defined and in Fig.1C the conductive properties of the uncovered parts outside the device regions are altered.

Fig. 2 represents a pattern of spacer defined fin grown around the original (sacrificial) pattern.

### Detailed description of the invention

Mesa isolation is a known technique, whereby in the circuits formed on semi-insulating substrate adjacent devices are isolated by etching through conducting layer. 'Islands' are thereby created in which devices are formed. While in these prior art solutions FinFETs are separated by removing semiconductor material, the present invention follows a different approach. However, the method of the invention is first presented in a much more general context.

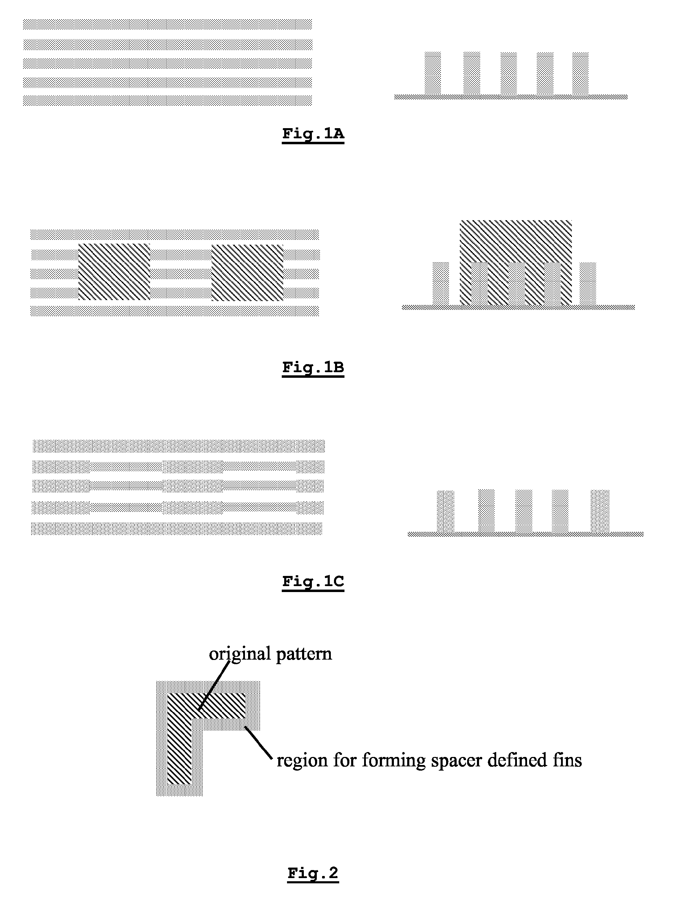

One starts from a high topography pattern of semiconductor material comprising at least one elevated line. By elevated line is meant a line having a non-zero aspect ratio (i.e. ratio of height to width), said line being elevated from the semiconductor surface, i.e. raised above the semiconductor surface, as is also shown in Fig.1. Alternatively one can start from a pattern, wherein the high topography line(s) is a semiconductor nanocarbon tube or a nanowire.
In a first step, a dense high topography line pattern of the semiconductor material with small pitch (i.e. small distance between the centres of two neighbouring features) and critical dimension is patterned. The dense pattern may for example be a pattern of parallel lines. Said lines can have a critical dimension of e.g. 15 nm. This allows performing a lithography step with the highest possible resolution of a state of the art lithography machine or allows the use of interferometric systems where two light rays under a certain angle are used to image grating structures (see for example http://www.amphibianlitho.com).
Fig. 1A shows both a top view and a cross-section.
In a second step device regions are defined (see Fig. 1B) in the pattern. A possible way to achieve this is by covering the device regions with a hard mask. In a preferred embodiment this can be achieved by covering the device regions with a non-oxidating material, like e.g. nitride. It is to be noted that by device region is meant a region wherein a complete device (like e.g. a finfet) can be formed, rather than just a part like a drain or a gate.
In a third step the electrical, more precisely the conductive, properties of the semiconductor material outside the device regions are altered. In a preferred embodiment the unwanted parts of the dense high topography pattern are converted into a dielectricum (Fig. 1C). In a particular embodiment a selective oxidation step is performed. In an alternative embodiment an implant can be used, that creates a PN junction serving as isolation between the device regions (with one type of dopant) and the semiconductor material outside the device regions having the opposite type of dopant.

The method is well suited for being applied in order to obtain spacer defined fins. In this case the dense high topography pattern of semiconductor material, in which device regions are defined, is obtained by a conventional patterning of dense parallel lines. These parallel lines are obtained in two steps by patterning dense parallel lines in a layer intended for creating spacer-defined lines (known as spacer defined fins). Spacer defined fins are created at all edges of a conventional pattern. After the dedicated layer is grown around the original pattern, the original pattern is removed, so a closed loop pattern is formed that follows the border of the original pattern (see Fig.2). This way one can obtain a line pattern with half the pitch of the original pattern. The present invention allows the use of each part of the closed loop by dividing the loop into electrically isolated parts.

The method as explained above can be applied to produce devices in a way similar to the structured ASIC approach. This approach aims to combine the advantages of an application specific design methodology and the much more cost efficient approach of programming FPGAs (Field Programmable Gate Arrays). A structured ASIC design uses therefore less power than the same design implemented in an FPGA. The critical and expensive lower levels of a structured ASIC form a common part, on top of which a specific logic function can be programmed in the upper levels of the fabrication process. The functionality of an integrated circuit is thereby defined in the lithography steps by reused masks combined with circuit specific masks for a few selected layers. The method of the invention is very suitable for providing said critical layers. The method is also applicable for FPGAs.

The procedure of the method for isolating structures according to the present invention may comprise the following steps :
1. Start with SOI wafers with 60nm Si,
2. Pattern the fins on SOI (160nm pitch, 40nm CD),
3. Deposit a thin pad oxide (15nm) to reduce stress,
4. Deposit a nitride layer (Si₃N₄, 80nm) to protect from oxidation,
5. 6nm high temperature oxide (HTO) deposition,
6. Active area photo,
7. Dry etch nitride, stop on oxide,
8. Strip resist
9. 15nm dry oxidation
10. Wet etch nitride,

The method according to the invention allows to create dummy structures with a uniform density. Another advantage is that the requirements for the active pattern lithography can be relaxed. The litho step in this method is relatively simple because the lithography conditions can be optimised for one uniform regular pattern, whereas in the prior art especially for small structures this represents a complex processing step. As a further advantage the method increases the mechanical stability of the fins.

The foregoing descriptions of embodiments of the present invention have been presented for purposes of illustration and description only. They are not intended to be exhaustive or to limit the present invention to the forms disclosed. Accordingly, many modifications and variations will be apparent to practitioners skilled in the art.

## Claims

1. Method for isolating structures of a semiconductor material, comprising the steps of :
- providing a pattern of said semiconductor material comprising at least one elevated line,
- defining device regions in said pattern, said device regions each comprising at least said at least one elevated line, and
- modifying the conductive properties of said semiconductor material outside said device regions, such that said device regions are electrically isolated.

2. Method for isolating structures as in claim 1, whereby the step of defining device regions is performed by covering said device regions with a hard mask.

3. Method for isolating structures as in claim 2, wherein said hard mask is a non-oxidising material.

4. Method for isolating structures as in claim 3, wherein said hard mask is formed of nitride.

5. Method for isolating structures as in any of claims 1 to 4, wherein said step of modifying the conductive properties is performed by turning said semiconductor material outside said device regions into dielectric material.

6. Method for isolating structures as in claim 5, wherein said step of modifying the conductive properties comprises a selective oxidation step.

7. Method for isolating structures as in any of claims 1 to 4, whereby said step of modifying the conductive properties comprises forming a PN junction between said device regions and said semiconductor material outside said device regions.

8. Method for isolating structures as in any of claims 1 to 7, whereby said dense high topography pattern is obtained by a lithographic patterning step comprising interferometry.

9. Method for isolating structures as in any of claims 1 to 8, whereby said dense high topography pattern comprises a plurality of parallel lines.

10. Method for isolating structures as in claim 9, whereby said plurality of parallel lines is obtained by patterning a dedicated layer arranged for creating spacer defined fins.

11. Method for isolating structures as in any of claims 1 to 10, whereby said semiconductor material is a SoI, a GoI or a SiGe layer.

12. Method for isolating structures as in any of claims 1 to 11, whereby said at least one elevated line is a semiconductor nanocarbon tube or a nanowire.

13. A multi-gate device comprising:
- a pattern comprising at least one elevated line of a semiconductor material,
- device regions defined in said pattern, said device regions each comprising at least said at least one elevated line, whereby said device regions are electrically isolated by isolation regions defined in said semiconductor material of said at least one elevated line.

14. Multi-gate device obtained by performing the steps of the method as in any of the claims 1 to 12, whereby said pattern of said semiconductor material comprises a plurality of elevated lines and whereby a device regions for said multi-gate device are defined.
